# EUROPÄISCHE PATENTSCHRIFT

(11) **EP 3 662 551 B1**
(45) Veröffentlichungstag und Bekanntmachung des Hinweises auf die Patenterteilung: **03.09.2025**
(21) Anmeldenummer: 18734216.7
(22) Anmeldetag: 26.06.2018
(51) Int. Cl.: H02H 1/00, H02H 3/38, H02H 3/44, H02H 7/18, B60L 50/00, B60L 3/00, B60L 3/04, B60L 58/10, G01R 31/52, G01R 31/3842, H02J 7/00, H02J 7/02, B60L 53/14, G01R 31/392

(54) **VERFAHREN ZUR ERKENNUNG VON STÖRLICHTBÖGEN BEI DER LADUNG VON ELEKTRISCHEN BATTERIESYSTEMEN**
METHOD FOR DETECTING ACCIDENTAL ARCS DURING THE CHARGING OF ELECTRICAL BATTERY SYSTEMS
PROCÉDÉ POUR LE REPÉRAGE D'ARCS ÉLECTRIQUES PARASITES PENDANT LA CHARGE DE SYSTÈMES DE BATTERIES ÉLECTRIQUES

(30) Priorität: 31.07.2017 DE 102017213174
(43) Veröffentlichungstag der Anmeldung: 10.06.2020
(73) Patentinhaber: Ellenberger & Poensgen GmbH, 90518 Altdorf (DE)
(72) Erfinder: MIKLIS, Markus, 90592 Pfeifferhütte (DE); REGAHL, Thomas, 91207 Lauf (DE); STROBL, Christian, 90419 Nürnberg (DE)
(74) Vertreter: FDST Patentanwälte
(86) Internationale Anmeldenummer: PCT/EP2018/067135
(87) Internationale Veröffentlichungsnummer: WO 2019/025083

(56) Entgegenhaltungen:
- EP-A1- 2 916 455
- DE-A1- 102011 106 297
- DE-A1- 102012 020 718

## Beschreibung

Die Erfindung betrifft ein Verfahren zur Erkennung von Störlichtbögen bei der Ladung von elektrischen Batteriesystemen. Als Batteriesystem wird bevorzugt jeweils ein Bleiakkumulator herangezogen. Die Erfindung betrifft ferner ein Verfahren zur Herstellung von elektrischen Batteriesystemen und eine Abschaltvorrichtung.

Als Autobatterien werden üblicherweise Bleiakkumulatoren herangezogen. Bei diesen sind üblicherweise sechs oder zwölf Batteriezellen mit jeweils 2 V in Reihe geschaltet. Jede Zelle weist jeweils zwei Elektroden aus Blei auf, die in einer verdünnten Schwefelsäure angeordnet sind, die als Elektrolyt dient. Im entladenen Zustand lagern sich an den beiden Elektroden eine Schicht aus Blei (II)-Sulfat ab. Im geladenen Zustand weist eine der beiden Elektroden, nämlich die positive Elektrode, eine Schicht aus Blei (IV)-Oxid auf, wohingegen die negativ gepolte Elektrode im Wesentlichen aus porösem Blei besteht. Zur Vermeidung eines Kurzschlusses zwischen den meist vergleichsweise dicht beieinander angeordneten Elektroden ist ein Separator zwischen diesen angeordnet, beispielsweise aus perforiertem, gewelltem Polyvinylchlorid (PVC).

Nach der mechanischen Herstellung ist es erforderlich, dass die Bleiakkumulatoren geladen werden, da diese meist im Automobilbereich als Starterbatterien eingesetzt werden, und nach einem Austausch der Starterbatterie das Kraftfahrzeug sofort einsatzbereit sein soll. Hierfür ist es erforderlich, dass bei Herstellung für eine bestimmte Zeitdauer eine elektrische Spannung an die Bleiakkumulatoren angelegt wird, und diese somit geladen werden. Damit in einer vergleichsweise kurzen Zeitdauer eine große Anzahl an Bleiakkumulatoren gefertigt wird, werden diese üblicherweise in Reihe geschaltet und mit einer elektrischen Spannungsquelle kontaktiert. Hierfür ist es erforderlich, dass einerseits eine elektrische Kontaktierung der Bleiakkumulatoren miteinander erfolgt. Dies erfolgt meist mittels losen Aufsetzens von Verbindungskabeln, vergleichsweise einfachen Klemmen oder dergleichen auf die einzelnen Anschlüsse der Bleiakkumulatoren. Hierbei ist es jedoch möglich, dass sich zwischen einem der Kabel und dem zugeordneten Anschluss, beispielsweise aufgrund einer Verschmutzung oder einer unsachgemäßen Montage, die Verbindung löst. Aufgrund der anliegenden elektrischen Spannung kann sich zwischen diesen Bestandteilen ein Lichtbogen ausbilden, über den weiterhin der elektrische Strom fließt. Mit anderen Worten wird der Ladevorgang auf diese Weise nicht unterbrochen.

Aufgrund des Anlegens der elektrischen Spannung wird die als Elektrolyt dienende Schwefelsäure dissoziiert, und es bildet sich zumindest teilweise Wasserstoff, welcher sich mit Sauerstoff mischt und somit Knallgas bildet. Dieses wird meist innerhalb des Gehäuses des jeweiligen Bleiakkumulators gehalten. Es ist jedoch auch möglich, dass sich aufgrund von Fertigungstoleranzen vergleichsweise viel Knallgas bildet. In diesem Fall werden, um ein Bersten des Gehäuses des Bleiackumulators zu vermeiden, aufgrund des Überdrucks Verschlüsse des Gehäuses geöffnet, sodass das Knallgas entweichen kann. Hierbei ist es möglich, dass sich eine derartige Knallgaswolke in den Bereich eines Lichtbogens bewegt. Aufgrund des mittels des Lichtbogens bereitgestellten Funkens, also insbesondere des Plasmas und der vergleichsweise hohen Temperatur dieses Plasmas, kann eine Entzündung der Knallgaswolke erfolgen. Dies kann zu einer Beschädigung der Anlage zur Herstellung der Bleiakkumulatoren und der dort angeordneten Bleiackumulatoren sowie zu einer Verletzung von etwaig anwesenden Personen führen.

Aus US 2017/0126036 A1 ist ein Ladesystem für Batterien bekannt. Auch WO 2017/079041 A1 zeigt ein Batteriesystem, mittels dessen Fehler bei der Ladung identifiziert werden können.

Aus DE 10 2012 020 718 A1 ist ein Verfahren zur Detektion eines Lichtbogens bei einem Kraftfahrzeug mit einem Mehrspannungsbordnetz bekannt. Das Kraftfahrzeug weist einen als Mehrspannungsbatterie ausgestalteten Energiespeicher auf, mittels dessen zwei unterschiedliche elektrische Spannungsquellen bereitgestellt werden.

Aus EP 2 916 455 A1 ist eine Einrichtung zum Detektieren eines seriellen Lichtbogens einer elektrischen Anlage bekannt, die eine Gleichspannungsquelle umfasst. Die Gleichspannungsquelle ist beispielsweise mittels mehrerer Photovoltaikmodule, elektrischer Akkumulatoren, Windräder oder mittels durch Verbrennungskraftmaschinen angetriebenen Generatoren bereitgestellt.

Der Erfindung liegt die Aufgabe zugrunde, eine Ladung von elektrischen Batteriesystemen zu verbessern, wobei insbesondere eine Explosionsgefahr verringert und/oder eine Zuverlässigkeit erhöht ist.

Hinsichtlich eines Verfahrens zur Erkennung von Störlichtbögen bei der Ladung von elektrischen Batteriesystemen wird diese Aufgabe durch die Merkmale des Anspruchs 1, hinsichtlich eines Verfahrens zur Herstellung von elektrischen Batteriesystemen durch die Merkmale des Anspruchs 9 und hinsichtlich einer Abschaltvorrichtung durch die Merkmale des Anspruchs 11 erfindungsgemäß gelöst. Vorteilhafte Weiterbildungen und Ausgestaltungen sind Gegenstand der jeweiligen Unteransprüche.

Das Verfahren dient der Erkennung von Störlichtbögen, also insbesondere der Ausbildung eines Plasmas zwischen zwei elektrisch geladenen Teilen, wobei mittels des Plasmas ein Stromfluss zwischen den beiden elektrisch geladenen Teilen erstellt oder aufrecht erhalten wird. Zur Ausbildung derartiger Störlichtbögen ("ARC") ist eine elektrische Spannung größer als eine Mindestspannung erforderlich. Diese Mindestspannung ist beispielsweise abhängig von Kontaktmaterialien, einer Stromstärke und/oder einer Lufttemperatur. Insbesondere ist die Mindestspannung im Wesentlichen gleich 15 Volt.

Mittels des Verfahrens werden hierbei Störlichtbögen bei der Ladung von elektrischen Batteriesystemen erkannt. Die Batteriesysteme sind elektrisch in Reihe zu einem String verschaltet. Der String selbst wird mittels eines Gleichspannungsumrichters gespeist. Somit erfolgt ein Energiefluss von dem Gleichspannungsumrichter zu dem String. Folglich bildet der String zumindest teilweise, vorzugsweise vollständig, die Last, und der Gleichspannungsumrichter bildet zumindest teilweise, vorzugsweise vollständig, die Quelle. Mit anderen Worten ist mittels des Gleichspannungsumrichters eine elektrische Gleichspannung an den String angelegt, die zweckmäßigerweise im Wesentlichen konstant ist. Beispielsweise sind hierbei mehrere Strings mit jeweils einer zugeordneten Regelung zueinander parallel geschaltet, die insbesondere zueinander baugleich sind. Der String weist zumindest zwei Batteriesysteme auf, vorzugsweise zwischen 5 Batteriesystemen und 50 Batteriesystemen, insbesondere zwischen 10 Batteriesystemen und 30 Batteriesystemen, und beispielsweise gleich 15 Batteriesysteme.

Insbesondere weist jedes Batteriesystem einen Elektrolyten auf, und/oder jedes Batteriesystem ist elektrochemisch. Der Elektrolyt jedes Batteriesystems ist insbesondere wässrig und/oder in einer wässrigen Lösung. Zweckmäßigerweise ist jedes Batteriesystem ein Batteriesystem mit wässrigem Elektrolyten. Zum Beispiel weist jedes Batteriesystem eine Anzahl an elektrochemischen Zellen auf, die geeignet verschalten sind. Geeigneterweise sind die Batteriesysteme baugleich. Die Batteriesysteme sind beispielsweise Akkumulatoren und somit wiederaufladbar. Insbesondere sind die Batteriesysteme offene Systeme. Mit anderen Worten tritt beispielsweise bei einer Ladung des Batteriesystems ein bestimmter chemischer Stoff aus oder wird beispielsweise aus der Umgebungsluft aufgenommen, wie insbesondere Luft, Sauerstoff oder Wasserstoff. Besonders bevorzugt ist das Batteriesystem ein Bleiakkumulator, wie eine sogenannte Starterbatterie für ein Kraftfahrzeug. Beispielsweise weist das Batteriesystem, insbesondere der Bleiakkumulator, im geladenen Zustand eine elektrische Spannung von 12 Volt oder 24 Volt auf (Nennspannungswerte). Zur Ladung des elektrischen Batteriesystems wird geeigneterweise ein Ladeprofil verwendet, welches eine abschnittsweise Strom- und/oder Spannungsregelung umfasst. Insbesondere wird eine elektrische Spannung (Ladespannung) von bis zu 2,4 Volt pro etwaiger Zelle der Batteriesysteme angelegt, zum Beispiel bis zu 13,8 Volt oder 14,8 Volt pro Batteriesystem. Aufgrund der Reihenschaltung ist es daher erforderlich, dass mittels des Gleichspannungsumrichters ein Vielfaches dieser Ladespannung bereitgestellt wird, wobei das Vielfache der Anzahl der Batteriesysteme pro String entspricht.

Beispielsweise erfolgt die Ladung der Batteriesysteme mittels einer Regelung einer an dem String anliegenden elektrischen Spannung oder einer Regelung eines über den elektrischen String fließenden elektrischen Stroms. Beispielsweise wird zunächst der über den String fließende elektrische Strom geregelt. Sofern die Batteriesysteme zu einem bestimmen Grad geladen sind, wird insbesondere auf eine Regelung der an den Batteriesystemen und somit an dem String anliegenden elektrischen Spannung gewechselt.

Das Verfahren sieht vor, dass in einem Arbeitsschritt ein zu einer an dem String anliegenden elektrischen Spannung korrespondierender erster Wert erstellt wird. Beispielsweise wird die an dem String anliegende elektrische Spannung direkt als erster Wert herangezogen. Alternativ hierzu wird anhand der elektrischen Spannung der erste Wert erstellt. Beispielsweise wird der erste Wert anhand der elektrischen Spannung berechnet oder anhand eines Kennfelds ermittelt. Zumindest jedoch ist der erste Wert von der anliegenden elektrischen Spannung abhängig. In einem weiteren Arbeitsschritt, der beispielsweise zeitlich vor oder zeitlich nach dem ersten Arbeitsschritt erfolgt, wird ein zweiter Wert erstellt, der zu dem über den String fließenden elektrischen Strom korrespondiert. Geeigneterweise erfolgt die Erstellung des ersten Werts und des zweiten Werts im Wesentlichen gleichzeitig. Bevorzugt basiert der erste Wert auf der elektrischen Spannung, die anliegt, wenn der elektrische Strom fließt, anhand derer der zweite Wert erstellt wird. Beispielsweise wird als zweiter Wert der elektrische Strom direkt herangezogen oder der zweite Wert wird anhand des elektrischen Stroms berechnet oder anhand eines Kennfelds ermittelt. Insbesondere wird zur Erstellung des ersten und des zweiten Werts geeigneterweise die elektrische Spannung bzw. der elektrische Strom gemessen, insbesondere direkt.

Als (eine) erste Bedingung wird in einem weiteren Arbeitsschritt überprüft, ob der erste Wert sich innerhalb eines ersten Zeitfensters um mehr als einen ersten Grenzwert ändert. Dabei wird lediglich überprüft, ob der erste Wert um mehr als den ersten Grenzwert ansteigt. Es wird überprüft, ob die elektrische Spannung, anhand derer der erste Wert erstellt wird, innerhalb des ersten Zeitfensters oder eines zu dem ersten Zeitfenster korrespondierenden Zeitabschnitts um einen bestimmten Wert ansteigt, der zu dem ersten Grenzwert korrespondiert. Vorzugsweise erfolgt die Überprüfung auf die erste Bedingung im Wesentlichen kontinuierlich, solange eine Speisung des Strings mittels des Gleichspannungsumrichters erfolgt.

Ferner wird als (eine) zweite Bedingung überprüft, ob der zweite Wert sich innerhalb eines zweiten Zeitfensters um mehr als einen zweiten Grenzwert ändert. Dabei wird lediglich überprüft, ob sich der zweite Wert um mehr als den zweiten Grenzwert verringert. Es wird überprüft, ob sich innerhalb eines zu dem zweiten Zeitfenster korrespondierenden Zeitabschnitts der elektrische Strom, anhand derer der zweite Wert erstellt wird, um mehr als einen bestimmten Wert absinkt, der zu dem zweiten Grenzwert korrespondiert. Zusammenfassend wird somit insbesondere implizit überprüft, ob die elektrische Spannung, die an dem String anliegt, innerhalb eines bestimmten Zeitabschnitts ansteigt, und ob der elektrische Strom innerhalb eines weiteren Zeitabschnitts absinkt. Beispielsweise wird im Wesentlichen kontinuierlich auf das Vorhandensein der zweiten Bedingung überprüft, zumindest solange der String mittels des Gleichspannungsumrichters gespeist wird. Alternativ hierzu wird lediglich dann auf das Vorhandensein der zweiten Bedingung überprüft, wenn die erste Bedingung erfüllt ist.

Geeigneterweise wird zur Bestimmung, ob sich der erste Wert bzw. der zweite Wert um mehr als den ersten bzw. zweiten Grenzwert ändern, jeweils die Ableitung des zeitlichen Verlaufs des ersten Werts bzw. des zweiten Werts erstellt, was eine Überprüfung auf die beiden Bedingungen vereinfacht. Der Lichtbogen wird erkannt, wenn die erste Bedingung und die zweite Bedingung innerhalb eines dritten Zeitfensters vorliegen. Beispielsweise wird der Lichtbogen lediglich dann erkannt, wenn die zweite Bedingung zeitlich nach Auftreten der ersten Bedingung auftritt. Geeigneterweise wird hierbei lediglich dann auch die zweite Bedingung überprüft, wenn die erste Bedingung vorliegt.

Zusammenfassend wird somit insbesondere überprüft, ob die an dem String anliegende elektrische Spannung ansteigt, und der über den String fließende elektrische Strom absinkt. Wenn der Lichtbogen auftritt, ist dieser beispielsweise zwischen einem elektrischen Kontakt eines der Batteriesysteme und einem die Batteriesysteme verbindenden Kabels oder dergleichen gebildet, sodass der Lichtbogen in Reihe zu den Batteriesystemen geschaltet ist. Aufgrund des Lichtbogens und aufgrund von (Ersatz-)Kapazitäten, die die einzelnen Batteriesysteme sowie Bestandteile des Gleichspannungsumrichters und weiterer Bestandteile, wie insbesondere ein den Gleichspannungsumrichter speisender Transformator, bereitstellen, steigt die über den vollständigen String anfallende elektrische Spannung an und der elektrische Strom fällt ab. Nach einer gewissen Einschwing- und Nachregelphase, die insbesondere größer als das erste, zweite und dritte Zeitfenster ist, erfolgt eine Normalisierung der elektrischen Spannung und des elektrischen Stroms, die an dem String anliegt bzw. über diesen fließt.

Aufgrund der Erkennung des Lichtbogens wird es ermöglicht, beispielsweise den Gleichspannungsumrichter abzuschalten oder den String von dem Gleichspannungsumrichter zu trennen oder zumindest elektrisch zu unterbrechen, sodass der Lichtbogen erlischt. Somit können etwaige lose elektrische Verbindungen vergleichsweise schnell erkannt werden, sodass der Lichtbogen abgeschaltet werden kann, bevor etwaige explosive Gase, die beim Laden der Batteriesysteme entstehen, in den Bereich des Lichtbogens/der losen Verbindung gelangen. Daher ist bei der Ladung der Batteriesysteme die Explosionsgefahr verringert und somit eine Zuverlässigkeit erhöht. Auch wird vermieden, dass aufgrund eines bestehenden Lichtbogens bei der Ladung und der erhöhten Temperatur ein Abbrand oder zumindest einer Verformung eines Pols des jeweiligen Batteriesystems erfolgt. Somit ist auch ein Ausschuss bei der Ladung der Batteriesysteme verringert. Aufgrund der Überprüfung auf die beiden Bedingungen ist das Verfahren vergleichsweise robust und unabhängig von deren Anzahl an auftretenden Lichtbögen sowie im Wesentlichen deren jeweilige zeitliche Dauer. Insbesondere wird das Verfahren zur Erkennung von Störlichtbögen lediglich dann ausgeführt, wenn eine Erstladung der Batteriesysteme erfolgt, die insbesondere wieder aufladbare Batteriesysteme, wie Bleiakkumulatoren, sind. Alternativ wird das Verfahren zur Erkennung von Störlichtbögen dann ausgeführt, wenn eine Widerladung und/oder Nachladung der Batteriesysteme erfolgt, die bereits mindestens einmal geladen wurden.

Bevorzugt wird der erste Wert mittels Mittelung der über ein viertes Zeitfenster an dem String anliegenden elektrischen Spannung erstellt. Mit anderen Worten wird die elektrische Spannung erfasst, die während des vierten Zeitfensters an dem String anliegt. Während des vierten Zeitfensters wird mehrmals die elektrische Spannung ermittelt, insbesondere mehr als zweimal, mehr als fünfmal oder mehr als zehnmal. Beispielsweise wird die elektrische Spannung kontinuierlich ermittelt oder beispielsweise in Abhängigkeit einer Weiterverarbeitung, die geeigneterweise digital erfolgt. Insbesondere ist die Ermittlung auf einen etwaigen A/D-Wandler abgestimmt, beispielsweise auf dessen Abtastrate. Zum Beispiel wird die elektrische Spannung jeweils jede Mikrosekunde, jede zweite Mikrosekunde, jede fünfte Mikrosekunde, jede zehnte Mikrosekunde, jede zwanzigste Mikrosekunde, jede fünfzigste Mikrosekunde oder jede hundertste Mikrosekunde neu erfasst. Insbesondere wird zur Mittelung der arithmetische Mittelwert verwendet, sodass zunächst die Summe der Werte für die anliegende elektrische Spannung gebildet und durch die Anzahl der Werte (Messwerte) geteilt wird. Geeigneterweise wird, sofern ein neuer Wert für die elektrische Spannung ermittelt wird, also insbesondere alle 10 Mikrosekunden, der erste Wert neu erstellt. Die während des vierten Zeitfensters ermittelten Werte der elektrischen Spannung werden gemittelt und dieser Wert wird zum Beispiel als erster Wert herangezogen. Mit anderen Worten wird der Mittelwert selbst als erster Wert herangezogen. Besonders bevorzugt jedoch wird die, insbesondere mittels numerischer Rechnung angenähert ermittelte, Ableitung des zeitlichen Verlaufs des Mittelwerts als erster Wert herangezogen und mit dem ersten Grenzwert verglichen.

Alternativ oder besonders bevorzugt in Kombination hierzu wird der zweite Wert mittels Mittelung über ein fünftes Zeitfenster des über den String fließenden elektrischen Stroms erstellt. Hierbei wird während des fünften Zeitfensters zweckmäßigerweise mehrfach der elektrische Strom erfasst, beispielsweise gemessen, und diese Werte (Messwerte) zur Mittelung herangezogen. Während des fünften Zeitfensters wird mehrmals der elektrische Strom ermittelt, insbesondere mehr als zweimal, mehr als fünfmal oder mehr als zehnmal. Beispielsweise wird der elektrische Strom kontinuierlich ermittelt (erfasst) oder beispielsweise in Abhängigkeit einer Weiterverarbeitung, die geeigneterweise digital erfolgt. Insbesondere ist die Ermittlung auf einen etwaigen A/D-Wandler abgestimmt, beispielsweise auf dessen Abtastrate. Geeigneterweise wird der arithmetische Mittelwert erstellt. Beispielsweise wird der Mittelwert selbst als zweiter Wert herangezogen. Besonders bevorzugt jedoch wird die Ableitung des zeitlichen Verlaufs des Mittelwerts als zweiter Wert herangezogen und mit dem zweiten Grenzwert verglichen.

Insbesondere werden zur Ermittlung des ersten bzw. zweiten Werts jeweils zwischen 100 Messwerte und 400 Messwerte, zum Beispiel 300 Messwerte, herangezogen. Vorzugsweise ist die Länge des vierten Zeitfensters gleich der Länge des fünften Zeitfensters, was eine Verarbeitung vereinfacht. Aufgrund der Mittelung werden kurzzeitige Strom- bzw. Spannungsspitzen geglättet, was eine fehlerhafte Identifizierung von Lichtbögen vermeidet. Zudem werden hierdurch etwaige Schwankungen einer Versorgungsspannung des Gleichspannungsumrichters berücksichtigt. Alternativ wird beispielsweise anstatt der Mittelung das Maximum oder das Minimum der während des vierten Zeitfensters anliegenden elektrischen Spannung bzw. des während des fünften fließenden elektrischen Stroms herangezogen.

Geeigneterweise wird jeweils ein gleitender Mittelwert gebildet, sodass, sofern weitere Messwerte bereitgestellt werden, bereits länger zurückliegende Messwerte zur Mittelwertbildung nicht mehr herangezogen werden. Zweckmäßigerweise ist die Länge des vierten und/oder fünften Zeitfensters konstant. Insbesondere wird jedes Mal, sofern ein neuer Messwert der elektrischen Spannung bzw. des elektrischen Stroms vorliegt, der erste bzw. zweite Wert neu ermittelt. Zur Ermittlung wird beispielsweise ein sogenannter FIFO-Speicher ("First in, First out") verwen-det, was die Berechnung vereinfacht. Hierbei sind insbesondere in dem Speicher lediglich die Werte hinterlegt, die zur Mittelung herangezogen werden, und anhand derer somit der erste bzw. zweite Wert erstellt wird. Beispielsweise wird zur Mittelwertsbildung von einem bereits erstellten Mittelwert ein Bruchteil eines aus dem Speicher zu löschenden Werts abgezogen und ein Bruchteil eines neuen zu speichernden Werts addiert.

Insbesondere ist die Länge des vierten Zeitfensters gleich dem Kehrwert des Produkts aus dem Doppelten der Anzahl der Phasen des Gleichspannungsumrichters und einer Speisefrequenz des Gleichspannungsumrichters. Mit anderen Worten wird zunächst das Doppelte der Anzahl der Phasen bestimmt, mittels derer der Gleichspannungsumrichter betrieben ist. Beispielsweise ist der Gleichspannungsumrichter an ein dreiphasiges Wechselstromnetz angeschlossen. In diesem Fall ist die Anzahl der Phasen gleich drei ("3"). Das Doppelte der Anzahl der Phasen entspricht insbesondere der Anzahl an Teilbrücken des Gleichspannungsumrichters. Sofern dieser insbesondere eine Brückenschaltung aufweist, die beispielsweise als B6-Schaltung aufgebaut ist und somit sechs Halbleiter aufweist, ist das Doppelte der Anzahl der Phasen gleich sechs ("6"). Wenn der Gleichspannungsumrichter an ein einphasiges Wechselstromnetz angeschlossen ist, ist das Doppelte gleich zwei ("2").

Die Speisefrequenz ist die Frequenz, die jede der einzelnen Phasen des Gleichspannungsumrichters aufweist, also beispielsweise 50 Hz oder 60 Hz. Bei einem dreiphasigen Gleichspannungsumrichter, dessen Speisefrequenz 60 Hz ist, ist die Länge des vierten Zeitfensters somit 1/360 s, also ca. 2,8 ms. Bei einem dreiphasigen Gleichspannungsumrichter, dessen Speisefrequenz 50 Hz ist, ist die Länge des vierten Zeitfensters somit 1/300 s, also ca. 3,3 ms. Alternativ wird jeweils ein ganzzahliges Mehrfaches hiervon herangezogen. Mit anderen Worten entspricht die Länge des vierten Zeitfensters dem Doppelten, Dreifachen, Vierfachen, ..... des Kehrwerts. Somit ist die Länge des vierten Zeitfensters gleich einem Vielfachen des Kehrwerts, also dem Einfachen, Zweifachen, Dreifachen, .... des Kehrwerts. Aufgrund der Länge des vierten Zeitfensters und der Mittelung zur Bestimmung des ersten Wertes werden Schwankungen der elektrischen Spannung im Wesentlichen vollständig geglättet, die aufgrund der Wechselspannung hervorgerufen werden, mittels der der Gleichspannungsumrichter betrieben ist. Somit ist ein fehlerhaftes Identifizieren des Lichtbogens vermieden.

Alternativ oder besonders bevorzugt in Kombination hierzu ist die Länge des fünften Zeitfensters gleich dem Kehrwert des Produkts aus dem Doppelten der Anzahl der Phasen des Gleichspannungsumrichters und einer Speisefrequenz des Gleichspannungsumrichters oder im ganzzahligen Mehrfachen davon. Insbesondere ist somit die Länge des fünften Zeitfensters somit 1/360 s, 2/360 s, 3/360 s, 4/360 s, 5/360 s ..., sofern der Gleichspannungsumrichter eine B6-Schaltung aufweist und mit einer Speisefrequenz von 60 Hz betrieben ist. Folglich werden Schwankungen des elektrischen Stroms, die aufgrund des Aufbaus des Gleichspannungsumrichters hervorgerufen und nicht aufgrund eines Lichtbogens bedingt sind, geglättet, was eine fehlerhafte Identifizierung von Lichtbögen vermeidet. Geeigneterweise ist die Länge des vierten Zeitfensters gleich der Länge des fünften Zeitfensters. Sofern der Gleichspannungsumrichter lediglich eine einzige Phase aufweist, ist die Länge des vierten bzw. fünften Zeitfensters gleich dem Kehrwert des Doppelten der Frequenz, mittels dessen der Gleichspannungsumrichter gespeist ist.

Beispielsweise wird die Länge des dritten Zeitfensters gleich der Länge des vierten Zeitfensters gewählt. Alternativ wird die Länge des dritten Zeitfensters gleich der Länge des fünften Zeitfensters gewählt. Besonders bevorzugt ist die Länge des dritten Zeitfenster gleich der Länge des vierten Zeitfensters und gleich der Länge des fünften Zeitfensters gewählt. Mit anderen Worten ist die Länge des vierten Zeitfensters gleich der Länge des fünften Zeitfensters. Aufgrund einer derartigen Wahl werden Artefakte vermieden und der etwaige Lichtbogen vergleichsweise schnell und sicher erkannt. Beispielsweise wird für die Länge des dritten Zeitfensters zwischen 1 Millisekunde und 65 Millisekunden, beispielsweise 3 Millisekunden, herangezogen. Alternativ wird als Länge für das dritte Zeitfenster 2 Millisekunden gewählt.

Der erste Grenzwert ist beispielsweise größer oder gleich 15 Volt gewählt. Zur Aufrechterhaltung des Lichtbogens ist eine elektrische Spannung von mindestens 15 Volt erforderlich, sodass, sofern der Lichtbogen auftritt und in Reihe zu dem Batteriesystem geschalten ist, eine Erhöhung der elektrischen Spannung von zumindest 15 Volt auftritt. Infolgedessen ist der Lichtbogen sicher erkannt, sofern die an dem String anliegende elektrische Spannung um mehr als 15 Volt ansteigt. Besonders bevorzugt ist der erste Grenzwert jedoch kleiner als 12 Volt gewählt. Alternativ oder besonders bevorzugt in Kombination hierzu ist der erste Grenzwert größer als 6 Volt. Beispielsweise ist der erste Grenzwert zwischen 10 Volt und 8 Volt. Sofern folglich der erste Wert um mehr als 6 Volt, 8 Volt, 10 Volt bzw. 12 Volt innerhalb des ersten Zeitfensters zunimmt, ist die erste Bedingung erfüllt. Bei einer derartigen Wahl für den ersten Grenzwert ist aufgrund der unteren Grenze ein fehlerhaftes Erkennen des Lichtbogens im Wesentlichen ausgeschlossen. Die obere Grenze ist geringer als die für den Lichtbogen erforderliche elektrische Spannung gewählt. Insbesondere, sofern eine Mittelung der elektrischen Spannung zur Erstellung des ersten Werts erfolgt, ist auf diese Weise der Lichtbogen bereits vergleichsweise schnell nach dessen Auftreten erkannt. Zudem ist es nicht erforderlich, dass der Lichtbogen im Wesentlichen kontinuierlich besteht. Es werden auf diese Weise auch Lichtbögen erkannt, die beispielsweise periodisch oder erratisch auftreten, beispielsweise aufgrund einer losen elektrischen Verbindung der Batteriesysteme untereinander, oder deren Dauer kürzer als das erste und/oder zweite Zeitfenster ist.

Beispielsweise wird als zweiter Grenzwert der Quotient aus dem ersten Grenzwert und dem Doppelten einer Systeminduktivität gewählt. Hierbei wird die Systeminduktivität beispielsweise mittels Messen bestimmt, berechnet oder geschätzt. Die Systeminduktivität beschreibt die Induktivität des zum Laden der Batteriesysteme herangezogenen Systems und wird maßgeblich insbesondere aufgrund eines etwaigen Transformators bestimmt, mittels dessen der Gleichspannungsumrichter gespeist ist. Zudem ist die Systeminduktivität insbesondere in geringem Maße abhängig von dem String, also der Verkabelung und der Batteriesysteme. Die Systeminduktivität ist insbesondere auf den Gleichspannungsumrichter und/oder die verwendeten Batteriesysteme sowie deren Anzahl abgestimmt. Beispielsweise ist der zweite Grenzwert größer oder kleiner als dieser Quotient. Sofern folglich der zweite Wert insbesondere um mehr als den Quotienten abnimmt, ist die zweite Bedingung erfüllt.

Insbesondere ist die Länge des ersten Zeitfensters gleich dem Kehrwert des Produkts aus dem Doppelten der Anzahl der Phasen des Gleichspannungsumrichters und einer Speisefrequenz des Gleichspannungsumrichters. Mit anderen Worten wird zunächst das Doppelte der Anzahl der Phasen bestimmt, mittels derer der Gleichspannungsumrichter betrieben ist. Beispielsweise ist der Gleichspannungsumrichter an ein dreiphasiges Wechselstromnetz angeschlossen. In diesem Fall ist die Anzahl der Phasen gleich drei ("3"). Das Doppelte der Anzahl der Phasen entspricht insbesondere der Anzahl an Teilbrücken des Gleichspannungsumrichters. Sofern dieser insbesondere eine Brückenschaltung aufweist, die beispielsweise als B6-Schaltung aufgebaut ist und somit sechs Halbleiter aufweist, ist das Doppelte der Anzahl der Phasen gleich sechs ("6"). Wenn der Gleichspannungsumrichter an ein einphasiges Wechselstromnetz angeschlossen ist, ist das Doppelte gleich zwei ("2").

Die Speisefrequenz ist die Frequenz, die jede der einzelnen Phasen des Gleichspannungsumrichters aufweist, also beispielsweise 50 Hz oder 60 Hz. Bei einem dreiphasigen Gleichspannungsumrichter, dessen Speisefrequenz 60 Hz ist, ist die Länge des ersten Zeitfensters somit 1/360 s, also ca. 2,8 ms. Bei einem dreiphasigen Gleichspannungsumrichter, dessen Speisefrequenz 50 Hz ist, ist die Länge des ersten Zeitfensters somit 1/300 s, also ca. 3,3 ms. Mit anderen Worten wird überprüft, ob sich der erste Wert innerhalb von 2,8 ms bzw. 3, 3 ms um mehr als den ersten Grenzwert ändert, und insbesondere um mehr als den ersten Grenzwert zunimmt. Alternativ wird jeweils ein ganzzahliges Mehrfaches hiervon herangezogen. Mit anderen Worten entspricht die Länge des ersten Zeitfensters dem Doppelten, Dreifachen, Vierfachen, ..... des Kehrwerts. Somit ist die Länge des ersten Zeitfensters gleich einem Vielfachen des Kehrwerts, also dem Einfachen, Zweifachen, Dreifachen, .... des Kehrwerts.

Alternativ oder besonders bevorzugt in Kombination hierzu ist die Länge des zweiten Zeitfensters gleich dem Kehrwert des Produkts aus dem Doppelten der Anzahl der Phasen des Gleichspannungsumrichters und einer Speisefrequenz des Gleichspannungsumrichters oder im ganzzahligen Mehrfachen davon. Insbesondere ist somit die Länge des zweiten Zeitfensters somit 1/360 s, 2/360 s, 3/360 s, 4/360 s, 5/360 s ..., sofern der Gleichspannungsumrichter eine B6-Schaltung aufweist und mit einer Speisefrequenz von 60 Hz betrieben ist.

Sofern der Gleichspannungsumrichter lediglich eine einzige Phase aufweist, ist die Länge des ersten bzw. zweiten Zeitfensters gleich dem Kehrwert des Doppelten der Frequenz, mittels dessen der Gleichspannungsumrichter gespeist ist. Vorzugsweise ist die Länge des ersten Zeitfensters gleich der Länge des zweiten Zeitfensters. Aufgrund einer derartigen Wahl für die Länge des ersten bzw. des zweiten Zeitfensters ist ein vergleichsweise sicheres Erkennen des Störlichtbogens ermöglicht, da die Änderungen der elektrischen Spannung und des elektrischen Stroms bei Auftreten des Störlichtbogens vergleichsweise zeitnah aufeinander folgen. Hierbei werden jedoch vergleichsweise kurzzeitige Schwankungen, beispielsweise aufgrund von Fertigungstoleranzen des Gleichspannungsumrichters nicht fehlerhaft als ein Lichtboden identifiziert. Geeigneterweise ist das erste und/oder zweite Zeitfenster anhand einer Abtastfrequenz bestimmt, insbesondere einer Frequenz, mittels derer ein etwaiger A/D-Wandler betrieben wird. Zum Beispiel ist die Länge des ersten Zeitfensters ein ganzzahliges Vielfaches eines zu der Abtastfrequenz korrespondierenden Zeitabschnitts.

Geeigneterweise wird der Lichtbogen nur erkannt, wenn die elektrische Spannung, die vor dem dritten Zeitfenster, innerhalb dessen sowohl die erste als auch die zweite Bedingung auftreten, an dem String anliegt, größer als ein dritter Grenzwert ist. Mit anderen Worten wird, wenn innerhalb des dritten Zeitfensters sowohl die erste Bedingung als auch die zweite Bedingung vorliegen, überprüft, ob direkt vor diesem dritten Zeitfenster die elektrische Spannung größer als der dritte Grenzwert war. Der dritte Grenzwert ist beispielsweise größer als 100 Volt, größer als 120 Volt und insbesondere kleiner als 200 Volt. Beispielsweise ist der dritte Grenzwert im Wesentlichen gleich 150 Volt. Zum Beispiel ist der dritte Grenzwert zwischen 50% und 75% des Produkts aus der Anzahl der etwaigen Zellen des Strings und 2 V. Alternativ oder in Kombination hierzu wird der Lichtbogen nur erkannt, wenn der vor dem dritten Zeitfenster über den String fließende elektrische Strom größer als ein vierter Grenzwert ist, wobei innerhalb dieses dritten Zeitfensters sowohl die erste als auch die zweite Bedingung erfüllt ist. Somit wird überprüft, ob direkt vor dem dritten Zeitfenster, innerhalb dessen sowohl die erste als auch die zweite Bedingung vorliegen, der über den String fließende elektrische Strom größer als ein vierter Grenzwert ist. Der vierte Grenzwert ist beispielsweise abhängig von den Batteriesystemen und/oder größer als 1 Ampere (A), 2 Ampere oder 3 Ampere und beispielsweise kleiner als 10 Ampere. Beispielsweise wird als vierter Grenzwert 5 Ampere herangezogen. Alternativ oder besonders bevorzugt in Kombination mit den beiden vorhergehenden Bedingungen wird der Lichtbogen nur erkannt, wenn während des dritten Zeitfensters, während dessen die erste und auch die zweite Bedingung erfüllt sind, der über den String fließende elektrische Strom größer als ein fünfter Grenzwert ist. Der fünfte Grenzwert ist beispielsweise größer als 0,5 Ampere, 1 Ampere, und beispielsweise kleiner als 3 Ampere oder 2 Ampere.

Aufgrund der weiteren Bedingungen ist sichergestellt, dass tatsächlich eine Ladung der Batteriesysteme erfolgt und das System bereits in einem eingeschwungenen und/oder stabilisierten Zustand ist. Mit anderen Worten ergeben sich die erste und zweite Bedingung nicht beispielsweise aufgrund von Einschalteffekten des Gleichspannungsumrichters oder sonstiger Bauteile. Auch werden während eines Einschaltvorgangs auftretende Lichtbögen nicht identifiziert. Bei Einschalten sowie im Wesentlichen kurz nach Einschalten und Beginn der Ladung der Batteriesysteme sind noch keine explosiven Gase gebildet, sodass keine Explosionsgefahr besteht. Alternativ zur Überprüfung auf die weiteren Bedingungen wird beispielsweise geprüft, ob das Laden der Batteriesysteme bereits für einen bestimmten Zeitraum erfolgte. Diese Information wird beispielsweise mittels eines Kabels, einer Leitung, eines Digitalsignals oder eines Bus-Systems übertragen. Hierbei wird der Lichtbogen lediglich dann erkannt, wenn das Laden der Batteriesysteme bereits für einen bestimmten Zeitraum erfolgte, insbesondere 10 Sekunden oder 1 Minute.

Das Verfahren zur Herstellung von elektrischen Batteriesystemen sieht vor, dass zunächst eine Anzahl an ungeladenen Batteriesystemen bereitgestellt wird. Als Batteriesysteme werden beispielsweise Akkumulatoren herangezogen, welche auf dem elektrochemischen Prinzip basieren. Insbesondere werden wiederaufladbare Batteriesysteme bereitgestellt, die einen Elektrolyten umfassen. Zur Bereitstellung werden beispielsweise zunächst Elektroden und ein Elektrolyt mechanisch in einem Gehäuse platziert. Als Batteriesysteme werden besonders bevorzugt Bleiackumulatoren herangezogen. Bei den ungeladenen Bleiakkumulatoren ist im Wesentlichen eine Anzahl an Elektroden, die aus Blei erstellt sind, und die geeignet miteinander verschalten sind, in einer Schwefelsäurelösung angeordnet.

Die ungeladenen Batteriesysteme werden elektrisch in Reihe zu einem String verschaltet. Beispielsweise werden auf die Pole jedes Batteriesystems ein Kabel oder dergleichen aufgesetzt oder daran befestigt und mit jeweils einem weiteren Pol eines der weiteren ungeladenen Batteriesysteme elektrisch kontaktiert. Der String wird elektrisch mit einem Gleichspannungsumrichter kontaktiert, beispielsweise direkt oder besonders bevorzugt über eine Abschaltvorrichtung. Mit anderen Worten wird der String mit der Abschaltvorrichtung und die Abschaltvorrichtung elektrisch mit dem Gleichspannungsumrichter kontaktiert. Mittels der Abschaltvorrichtung ist insbesondere eine elektrische Trennung oder zumindest eine elektrische Unterbrechung des Strings von dem Gleichspannungsumrichter ermöglicht. Die Verschaltung der ungeladenen Batteriesysteme zu dem String und die Kontaktierung mit dem Gleichspannungsumrichter erfolgt beispielsweise in einem einzigen Verfahrensschritt.

In einem weiteren Verfahrensschritt wird mittels des Gleichspannungsumrichters eine elektrische Spannung an den String angelegt und ein elektrischer Stromfluss über den String erstellt. Vorzugsweise wird hierfür die Abschaltvorrichtung geeignet angesteuert. Die an dem String angelegte elektrische Spannung ist gleich dem Produkt aus der Anzahl der Batteriesysteme und der Ladespannung, die für eines der Batteriesysteme benötigt wird, und beispielsweise im Wesentlichen gleich 400 Volt. Der elektrische Strom ist insbesondere zwischen 5 Ampere und 100 Ampere, zwischen 10 Ampere und 90 Ampere und beispielsweise zwischen 30 Ampere und 80 Ampere.

Zudem wird ein Verfahren zur Erkennung von Störlichtbögen bei der Ladung von elektrischen Batteriesystemen ausgeführt. Hierbei wird ein zu einer an dem String anliegenden elektrischen Spannung korrespondierender erster Wert erstellt. Ferner wird ein zu einem über den String fließenden elektrischen Strom korrespondierender zweiter Wert erstellt. Als erste Bedingung wird überprüft, ob der erste Wert sich innerhalb eines ersten Zeitfensters um mehr als einen ersten Grenzwert ändert. Hierbei wird überprüft, ob der erste Wert innerhalb des ersten Zeitfensters um mehr als den ersten Grenzwert zunimmt. Als zweite Bedingung wird überprüft, ob der zweite Wert sich innerhalb eines zweiten Zeitfensters um mehr als einen zweiten Grenzwert ändert. Hierbei wird überprüft, ob der zweite Wert um mehr als den zweiten Grenzwert abnimmt. Zur Ermittlung der Bedingungen wird insbesondere die Ableitung des zeitlichen Verlaufs des ersten und/oder zweiten Werts bestimmt.

Der Lichtbogen ist erkannt, wenn die erste Bedingung und die zweite Bedingung innerhalb eines dritten Zeitfensters vorliegen. Die Länge des dritten Zeitfensters ist insbesondere im Wesentlichen gleich 3 Millisekunden oder beispielsweise kleiner, insbesondere gleich 2 Millisekunden oder 1 Millisekunde. Somit ist vergleichsweise sicher das Auftreten eines Lichtbogens bei der Herstellung der elektrischen Batteriesysteme bekannt.

Sofern beispielsweise eine bestimmte Zeitspanne seit Anliegen der elektrischen Spannung und Erstellen des elektrischen Stromflusses vergangen ist und/oder eine bestimmte elektrische Stromstärke und/oder eine bestimmte elektrische Spannung an dem String anliegt, sind die Batteriesysteme vollständig geladen und somit erstellt. In diesem Fall wird vorzugsweise die Bestromung unterbrochen und/oder das Anlegen der elektrischen Spannung unterbrochen. Zudem wird insbesondere die Verschaltung der Batteriesysteme untereinander aufgehoben. Mit anderen Worten wird der String erneut aufgetrennt, sodass die einzelnen Batteriesysteme separat sind. Diese werden beispielsweise verladen und/oder verpackt.

Beispielsweise wird zunächst nach Anlegen der elektrischen Spannung und Erstellung des elektrischen Stromflusses der elektrische Strom auf einen bestimmten Wert geregelt. Nach Ablauf einer bestimmten Zeitdauer erfolgt geeigneterweise eine Regelung auf eine bestimmte elektrische Spannung. Vorzugsweise werden die Batteriesysteme während des Ladens, also solange die elektrische Spannung an dem String anliegt, und/oder solange der elektrische Stromfluss besteht, gekühlt. Hierfür werden die Batteriesysteme beispielsweise mittels Kühlluft beaufschlagt. Alternativ oder in Kombination hierzu sind die Batteriesysteme beispielsweise in einem Kühlbecken angeordnet, welches mit einer Flüssigkeit zumindest teilweise gefüllt ist, insbesondere mit Wasser.

Zweckmäßigerweise wird der String elektrisch von dem Gleichspannungsumrichter getrennt oder zumindest elektrisch unterbrochen, wenn der Lichtbogen erkannt wird. Mit anderen Worten wird eine Bestromung des Strings und somit das Laden der Batteriesysteme beendet. Auch wird das Anlegen der elektrischen Spannung an den String beendet. Infolgedessen bricht der Lichtbogen zusammen und das Plasma, welches zur Aufrechterhaltung des Lichtbogens dient, kühlt ab. Daher befinden sich in der Umgebung des Strings keine Funken, sodass sich eine etwaige Knallgaswolke, die beispielsweise aufgrund der Ladung entsteht, insbesondere aufgrund einer Dissoziation von Wasser, nicht entzünden kann.

Die Abschaltvorrichtung dient der elektrischen Unterbrechung (Abschaltung), beispielsweise Trennung, eines Strings von einer Gleichspannungsquelle, insbesondere einem Gleichspannungsumrichter. Insbesondere dient Abschaltvorrichtung der galvanischen Trennung des Strings von dem Gleichspannungsumrichter. Der String selbst weist eine Anzahl von elektrisch in Reihe geschalteten Batteriesystemen auf, wie insbesondere Bleiakkumulatoren. Die Abschaltvorrichtung umfasst einen elektrischen Stromsensor, mittels dessen es ermöglicht ist, einen elektrischen Strom zu erfassen. Ferner weist die Abschaltvorrichtung einen elektrischen Spannungssensor auf, mittels dessen bei Betrieb eine elektrische Spannung erfasst wird. Bevorzugt weist die Abschaltvorrichtung einen Schalter auf, wie beispielsweise ein Relais oder einen Halbleiterschalter, wie einen Leistungstransistor, insbesondere einen MOSFET, IGBT oder Thyristor. Beispielsweise weist die Abschaltvorrichtung eine Schnittstelle zu einem Bus-System oder dergleichen auf. Auch weist die Abschaltvorrichtung eine Steuereinheit auf, die insbesondere signaltechnisch mit dem elektrischen Stromsensor und/oder dem elektrischen Spannungssensor gekoppelt ist. Beispielsweise umfasst die Steuereinheit einen A/D-Wandler, mittels dessen bei Betrieb ein Eingangssignal des Stromsensors bzw. des Spannungssensors in ein digitales Wort gewandelt wird. Zweckmäßigerweise ist der Schalter und/oder die Schnittstelle ebenfalls mit der Steuereinheit gekoppelt, sodass dieser mittels der Steuereinheit bedienbar ist. Hierbei sind der elektrische Stromsensor, der elektrische Spannungssensor und der Schalter zweckmäßigerweise derart angeordnet, dass, sofern die Abschaltvorrichtung zwischen dem Gleichspannungsumrichter und den String elektrisch geschaltet ist, mittels des elektrischen Stromsensors bei Betrieb ein über den String fließender elektrischer Stromfluss erfasst wird. Mittels des elektrischen Spannungssensors wird bei Betrieb eine an dem String anliegende elektrische Spannung erfasst. Mittels des Schalters ist es möglich, einen Stromfluss von dem Gleichspannungsrichter zu dem String zu erstellen oder zu unterbrechen. Mittels der Schnittstelle ist es ermöglicht, ein Steuersignal oder ein Telegramm auszugeben, insbesondere auf das Bus-System (Datenbus).

Die Steuereinheit ist gemäß einem Verfahren betrieben, bei dem ein zu einer an dem String anliegenden elektrischen Spannung korrespondierender erster Wert erstellt wird. Ferner wird ein zu einem über den String fließenden elektrischen Strom korrespondierender zweiter Wert erstellt. Als erste Bedingung wird überprüft, ob der erste Wert innerhalb eines ersten Zeitfensters um mehr als einen ersten Grenzwert ansteigt, und als zweite Bedingung wird überprüft, ob der zweite Wert sich innerhalb eines zweiten Zeitfensters um mehr als einen zweiten Grenzwert verringert. Ein Lichtbogen wird erkannt, wenn die erste Bedingung und die zweite Bedingung innerhalb eines dritten Zeitfensters vorliegen. Sofern der Lichtbogen erkannt ist, wird insbesondere der Schalter derart angesteuert, dass der String elektrisch nicht mehr von dem Gleichspannungsumrichter gespeist wird. Mit anderen Worten wird der Schalter insbesondere geöffnet. Alternativ oder in Kombination wird ein Steuerbefehl oder Telegramm über die Schnittstelle ausgegeben. Mittels des Steuerbefehls bzw. des Telegramms wird bevorzugt der Gleichspannungsumrichter abgeschaltet. Die Steuereinheit ist geeignet, insbesondere vorgesehen und eingerichtet, dieses Verfahren durchzuführen.

Die im Zusammenhang mit dem Verfahren zur Erkennung von Störlichtbögen bei der Ladung von elektrischen Batteriesystemen ausgeführten Weiterbildungen und Vorteile sind sinngemäß auch auf das Verfahren zur Herstellung von elektrischen Batteriesystemen und/oder die Abschaltvorrichtung zu übertragen sowie umgekehrt als auch untereinander.

Nachfolgend wird ein Ausführungsbeispiel der Erfindung anhand einer Zeichnung näher erläutert. Darin zeigen:
- Fig. 1: ein Verfahren zur Herstellung von elektrischen Batteriesystemen, mit einem Verfahren zur Erkennung von Störlichtbögen bei der Ladung von elektrischen Batteriesystemen,
- Fig. 2: schematisch vereinfacht eine Anzahl an Batteriesystemen, die elektrisch in Reihe zu einem String verschaltet sind, der mittels eines Gleichspannungsumrichters gespeist wird,
- Fig. 3: eine Abschaltvorrichtung zur elektrischen Unterbrechung des Strings von dem Gleichspannungsumrichter,
- Fig. 4: einen zeitlichen Verlauf einer an dem String anliegenden elektrischen Spannung bei Auftritt des Störlichtbogens,
- Fig. 5: einen zeitlichen Verlauf eines über den String fließenden elektrischen Stroms bei Auftritt des Störlichtbogens,
- Fig. 6: einen zeitlichen Verlauf eines ersten Werts bei Auftritt des Störlichtbogens, und
- Fig. 7: einen zeitlichen Verlauf eines zweiten Werts bei Auftritt des Störlichtbogens.

Einander entsprechende Teile sind in allen Figuren mit den gleichen Bezugszeichen versehen.

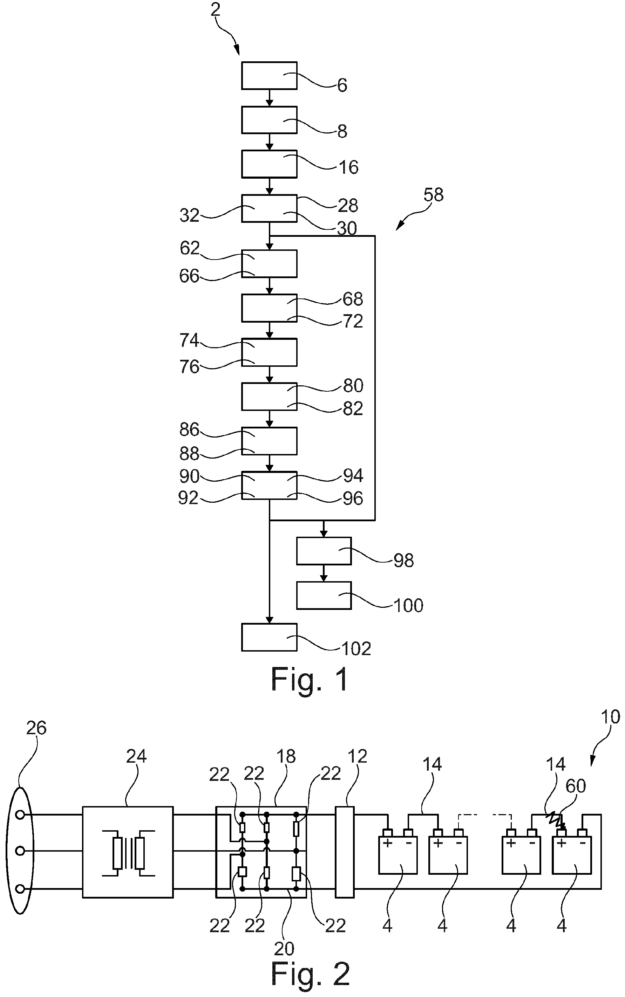

In Fig. 1 ist ein Verfahren 2 zur Herstellung von elektrischen Batteriesystemen 4 in Form von Bleiakkumulatoren dargestellt. In einem ersten Arbeitsschritt 6 werden die ungeladenen Batteriesysteme 4 bereitgestellt. In einem zweiten Arbeitsschritt 8 werden die ungeladenen Batteriesysteme 4 miteinander in Reihe zu einem String 10 und mit einer Abschaltvorrichtung 12 verschaltet, wie in Fig. 2 dargestellt. Hierbei ist jeweils ein Minus-Pol eines der Batteriesysteme 4 mit einem Plus-Pol jeweils eines weiteren der Batteriesysteme 4 zur Ausbildung des Strings 10 mittels jeweils einer Brücke 14 in Form von einem Kabel elektrisch kontaktiert. Die beiden Anschlussenden des Strings 10 sind elektrisch mit der Abschaltvorrichtung 12 kontaktiert.

In einem dritten Arbeitsschritt 16, der beispielsweise zeitgleich zu dem zweiten Arbeitsschritt, zeitlich vorher oder zeitlich nachfolgend erfolgt, wird die Abschaltvorrichtung 12 mit einem Gleichspannungsumrichter 18 elektrisch kontaktiert. Der Gleichspannungsumrichter 18 weist eine Brückenschaltung 20 mit sechs Halbleiterschaltern 22 in Form von MOSFETs oder Thyristoren auf. Alternativ sind die Halbleiterschalter 22 Leitungshalbleiterdioden. Die Brückenschaltung 20 ist somit eine B6-Schaltung und weist folglich sechs Teilbrücken auf. Der Gleichspannungsumrichter 18 wird mittels eines dreiphasigen Transformators 24 gespeist, der mit einem dreiphasigen Wechselstromnetz 26 elektrisch kontaktiert ist. Das Wechselstromnetz 26 weist somit drei Phasen auf, wobei jede Phase sinusförmig ist und eine Frequenz von 60 Hertz aufweist.

In einem vierten Arbeitsschritt 28, der zeitlich nachfolgend erfolgt, wird mittels des Gleichspannungsumrichters 18 eine elektrische Spannung 30 an die Abschaltvorrichtung 12 und somit an den String 10 angelegt. Ferner wird aufgrund der elektrischen Spannung 30 ein Fluss eines elektrischen Stroms 32 über die Abschaltvorrichtung 12 und über den String 10 erstellt. Mittels des Gleichspannungsumrichters 18 werden hierbei eine elektrische Spannung von 392 Volt und ein elektrischer Stromfluss von 50 Ampere bereitgestellt, wobei 28 Batteriesysteme 4 bereitgestellt sind. Zudem erfolgt zunächst eine Regelung auf den gewünschten elektrischen Strom 32. Nach einem bestimmten Zeitabschnitt erfolgt eine Regelung auf die elektrische Spannung 30.

Die Abschaltvorrichtung 12 ist in Fig. 2 schematisch vereinfacht dargestellt und weist einen Hinleiter 34 und einen Rückleiter 36 auf. Der Hinleiter 34 erstreckt sich zwischen einem ersten Anschluss 38 und einem zweiten Anschluss 40 und ist beispielsweise mittels einer Stromschiene gebildet. Am ersten Anschluss 38 ist im Montagezustand einer der Anschlüsse des Gleichspannungsumrichters 38 elektrisch angeschlossen. An dem zweiten Anschluss 40 ist im Montagezustand einer der Anschlüsse des Strings 10 angeschlossen. Der Rückleiter 36 erstreckt sich zwischen einem dritten Anschluss 42 und einem vierten Anschluss 44, wobei an dem dritten Anschluss 42 der verbleibende Anschluss des Gleichspannungsumrichters 18 und an dem vierten Anschluss 44 der verbleibende Anschluss des Strings 10 im Montagezustand angeschlossen ist. In den Rückleiter 36 ist ein Schalter 46 in Form eines Relais eingebracht, sodass mittels des Schalters 46 ein elektrischer Stromfluss zwischen dem dritten Anschluss 42 und dem vierten Anschluss 44 unterbrechbar ist. Der Schalter 46 ist signaltechnisch mit einer Steuereinheit 48 verbunden, sodass mittels der Steuereinheit 48 eine Bedienung des Schalters 46 erfolgt.

Ferner weist die Abschaltvorrichtung 12 einen elektrischen Spannungssensor 50 auf, der einen A/D-Wandler umfasst. Mittels des elektrischen Spannungssensors 50 wird bei Betrieb eine zwischen dem zweiten Anschluss 40 und dem vierten Anschluss 44 anliegende elektrische Spannung erfasst und in ein digitales Wort gewandelt, welches an die Steuereinheit 48 weitergeleitet wird. Hierbei wird mittels des elektrischen Spannungssensors 50 bei Betrieb alle 10 Mikrosekunden die elektrische Spannung erneut erfasst. Ferner weist die Abschaltvorrichtung 12 einen elektrischen Stromsensor 52 zur Messung eines zwischen dem dritten Anschluss 42 und dem vierten Anschluss 44 fließenden elektrischen Stroms auf. Der elektrische Stromsensor 52 umfasst eine Sensorsonde 54. Mittels der Sensorsonde 54 wird der auf dem Rückleiter 36 fließende elektrische Strom erfasst. Zudem weist der elektrische Stromsensor 52 einen A/D-Wandler 56 auf, mittels dessen die Messwerte der Sensorsonde 54 in ein digitales Wort gewandelt und an die Steuereinheit 48 weitergeleitet werden. Mittels des A/D-Wandlers 56 wird hierbei bei Betrieb alle 10 Mikrosekunden jeweils ein neues digitales Wort erstellt.

Während des Verfahrens 2 zur Herstellung der elektrischen Batteriesysteme 4 wird ferner ein Verfahren 58 zur Erkennung von Störlichtbögen 60 durchgeführt, wobei sich der Störlichtbogen 60 beispielsweise zwischen einem Pol eines der Batteriesysteme 4 und der zugeordneten Brücke 14 ausbildet, beispielsweise da sich die Brücke 14 von dem zugeordneten Pol aufgrund einer fehlerhaften Befestigung löst. Das Verfahren 58 zur Erkennung von Störlichtbögen 60 sieht vor, dass in einem fünften Arbeitsschritt 62 anhand der mittels des elektrischen Spannungssensors 50 erfassten und an dem String 10 anliegenden elektrischen Spannung 30 ein erster Wert 64 erstellt wird. Hierfür wird mittels des elektrischen Spannungssensors 50 alle 10 Mikrosekunden ein neuer Wert (Messwert) der elektrischen Spannung erfasst. Diese Messwerte werden über ein viertes Zeitfenster 66 gemittelt und somit der arithmetische Mittelwert dieser Messwerte erstellt. Der erste Wert 64 ist die zeitliche Ableitung des Verlaufs des Mittelwerts der elektrischen Spannung 30.

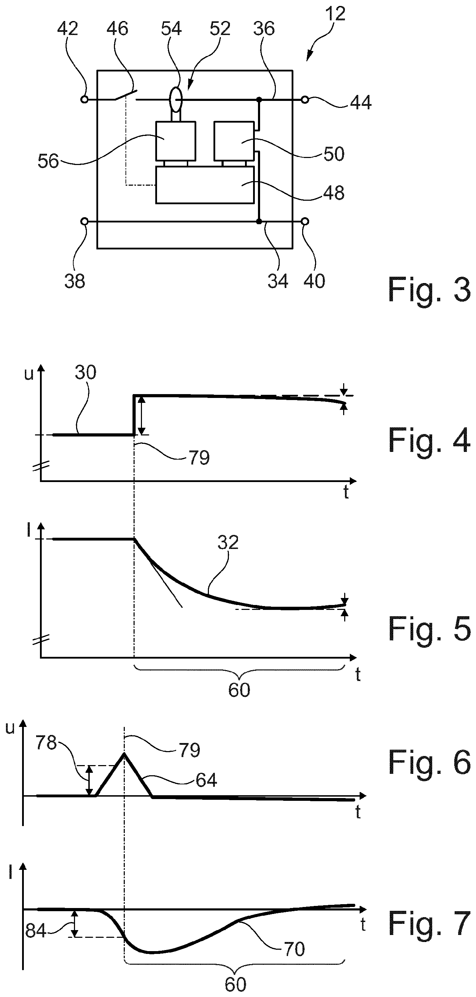

Der zeitliche Verlauf des Mittelwerts der elektrischen Spannung 30 ist in Fig. 4 und der zeitliche Verlauf des ersten Wertes 64 ist in Fig. 6 dargestellt. Die Länge des vierten Zeitfensters 66 ist gleich dem Kehrwert aus dem Produkt aus dem Doppelten der Anzahl der Phasen des Gleichspannungsumrichters 18 und einer Speisefrequenz des Gleichspannungsumrichters 18. Die Anzahl der Phasen des Gleichspannungsumrichters 18 ist hierbei drei und die Speisefrequenz gleich 60 Hertz, sodass ca. 270 Messwerte zur Erstellung jeweils eines der Mittelwerte und somit ca. 560 eines der ersten Werte 64 beitragen. Zur Mittelwertbildung werden hierbei beispielsweise sämtliche Messwerte erneut addiert oder ein bereits erstellter Mittelwert herangezogen und von diesem der zeitlich älteste erste Wert 64 abgezogen und der zeitlich neueste erste Wert 64 hinzuaddiert.

In einem sechsten Arbeitsschritt 68 wird anhand des mittels des elektrischen Stromsensors 52 erfassten elektrischen Stroms 32 ein zweiter Wert 70 erstellt.

Hierfür wird zunächst der arithmetische Mittelwert des über den String 10 fließenden elektrischen Stroms 32 über ein fünftes Zeitfenster 72 erstellt. Der zeitliche Verlauf des Mittelwerts des elektrischen Stroms 32 ist in Fig. 5 gezeigt. Der zweite Wert 70 ist die zeitliche Ableitung des Verlaufs des Mittelwerts und in Fig. 7 dargestellt. Die Länge des fünften Zeitfensters 72 ist konstant und gleich der Länge des vierten Zeitfensters 66 und somit gleich dem Kehrwert des Produkts aus dem Doppelten der Anzahl der Phasen des Gleichspannungsumrichters 18 und der Speisefrequenz des Gleichspannungsumrichters 18. Aufgrund der Wahl der Länge des vierten sowie fünften Zeitfensters 66, 72 erfolgt eine Mittelung über etwaige Rippel in der elektrischen Spannung 30 sowie dem elektrischen Strom 32, die aufgrund der einzelnen Phasen des Gleichspannungsumrichters 18 hervorgerufen werden, sodass der Mittelwert, sofern der Lichtbogen 60 nicht auftritt, im Wesentlichen konstant ist.

Die Steuereinheit 48 weist zwei Speicher auf, die nach dem FIFO-Prinzip arbeiten. Die Messwerte des elektrischen Stromsensors 52 werden hierbei in dem einen der Speicher und die Messwerte des elektrischen Spannungssensors 50 in dem anderen der beiden Speicher hinterlegt. Beide Speicher sind baugleich und weisen eine Anzahl von im Wesentlichen 270 Speicherplätzen auf. Sämtliche innerhalb des Speichers hinterlegten Messwerte werden hierbei zur Bildung des jeweiligen Mittelwerts der elektrischen Spannung 30 bzw., des elektrischen Stroms 32 herangezogen.

In einem siebten Arbeitsschritt 74 wird überprüft, ob sich der erste Wert 64 innerhalb eines ersten Zeitfensters 76 um mehr als einen ersten Grenzwert 78 ändert. Der erste Grenzwert 78 ist kleiner als 12 Volt und größer als 6 Volt gewählt und ist gleich 8 Volt. Als Länge für das erste Zeitfenster 76 werden 10 Mikrosekunden gewählt. Folglich wird überprüft, ob sich der erste Wert 64 innerhalb der Zeitspanne, die zwischen der erneuten Ermittlung des ersten Werts 64 liegt, um mehr als den ersten Grenzwert 78 ändert. Sofern der Steuerlichtbogen 60 in einem Zündzeitpunkt 79 zündet, steigt die elektrische Spannung 30 um denjenigen Wert an, der zur Aufrechterhaltung des in Reihe zu den Batteriesystemen 4 geschalteten Störlichtbogens 60 erforderlich ist. Diese elektrische Spannung ist mindesten 15 Volt.

In einem achten Arbeitsschritt 80 wird als zweite Bedingung überprüft, ob sich der zweite Wert 70 innerhalb eines zweiten Zeitfensters 82 um mehr als einen zweiten Grenzwert 84 ändert. Die Länge des zweiten Zeitfensters 82 ist gleich der Länge des ersten Zeitfensters 76 und gleich 10 Mikrosekunden, sodass jedes Mal dann, wenn der zweite Wert 70 erneut ermittelt wird, auch überprüft wird, ob sich dieser um mehr als den zweiten Grenzwert 84 geändert hat. Als zweiter Grenzwert 84 wird der Quotient aus dem ersten Grenzwert 78, also 10 Volt und dem Doppelten einer Systeminduktivität, herangezogen. Die Systeminduktivität ist hierbei abhängig von dem Transformator 24 sowie einer Kabellänge der Brücken 14 und sonstiger Kabellängen als auch der Anzahl der einzelnen Batteriesysteme 4.

In einem neunten Arbeitsschritt 86 wird überprüft, ob die erste Bedingung und die zweite Bedingung innerhalb eines dritten Zeitfensters 88 vorliegen. Mit anderen Worten wird überprüft, ob zwischen der Änderung des ersten Werts 74 um mehr als den ersten Grenzwert 78 und der Änderung des zweiten Werts 70 um mehr als den zweiten Grenzwert 84 innerhalb des jeweiligen Zeitfensters 76, 82 weniger als die Länge des dritten Zeitfensters 88 vergangen ist. Die Länge des dritten Zeitfensters 88 wird hierbei gleich der Länge des vierten und des fünften Zeitfensters 66, 72 gewählt und es ist somit gleich 1/360 s.

Sofern die erste und die zweite Bedingung erfüllt sind, wird in einem zehnten Arbeitsschritt 90 überprüft, ob vor dem dritten Zeitfenster 88, innerhalb dessen sowohl die erste als auch die zweite Bedingung erfüllt sind, die an dem String 10 anliegende elektrische Spannung 30 größer als ein dritten Grenzwert 92 war, der 150 Volt beträgt. Ferner wird überprüft, ob der vor dem dritten Zeitfenster 88, innerhalb dessen sowohl die erste als auch die zweite Bedingung erfüllt sind, der über den String 10 fließende elektrische Strom 32 größer als ein vierter Grenzwert 94 war, der 5 Ampere ist. Zusätzlich wird überprüft, ob während des vollständigen dritten Zeitfensters 88, innerhalb dessen sowohl die erste als auch die zweite Bedingung erfüllt sind, der über den String 10 fließende elektrische Strom 32 größer als ein fünfter Grenzwert 96 ist. Als fünfter Grenzwert 96 wird 2 Ampere herangezogen.

Sofern diese drei weiteren Bedingungen und die erste als auch die zweite Bedingung erfüllt sind, wird in einem elften Arbeitsschritt 98 der Lichtbogen 60 erkannt. Hierbei wird beispielsweise eine Meldung ausgegeben. Zudem wird im Anschluss hieran ein zwölfter Arbeitsschritt 100 ausgeführt, bei dem der Schalter 46 betätigt und somit der String 10 elektrisch von dem Gleichspannungsumrichter 58 getrennt wird. Sofern die erste und die zweite Bedingung entweder gar nicht erfüllt sind oder nicht innerhalb des dritten Zeitfensters 88 vorliegen, wird kein Lichtbogen 60 erkannt und nach Ablauf einer bestimmten Zeitspanne in Abhängigkeit einer Kennlinienvorgabe und/oder in Abhängigkeit einer von dem String 10 bereitgestellten/anliegenden elektrischen Spannung/elektrischen Strom in einem dreizehnten Arbeitsschritt 102 die Bestromung des Strings 10 mittels des Gleichspannungsumrichters 18 beendet. Zudem werden die Brücken 14 gelöst und die nunmehr geladenen Batteriesysteme 4 entfernt. Auch erfolgt keine (fälschliche) Erkennung des Lichtbogens 60, wenn zwar die erste und die zweite Bedingung innerhalb des dritten Zeitfensters 88 erfüllt sind, jedoch die vor dem dritten Zeitfenster 88 an dem String anliegende elektrische Spannung nicht größer als der dritte Grenzwert war, oder der vor dem dritten Zeitfenster über den String 10 fließende elektrisch Strom 32 nicht größer als der vierte Grenzwert war, oder der während des dritten Zeitfensters 88 über den String 10 fließende elektrische Strom 32 nicht größer als der fünfte Grenzwert 96 ist.

Zusammenfassend wird die Ladung der einzelnen Batteriesysteme 4 unterbrochen, wenn der Lichtbogen 60 erkannt wurde. Auf diese Weise wird vermieden, dass sich eine etwaige Knallgaswolke, die bei der Ladung entsteht, entzündet. Zudem können die einzelnen Brücken 14 und/oder die einzelnen Pole der Batteriesysteme 4 nach Erkennung des Lichtbogens 60 untersucht sowie gegebenenfalls ersetzt werden. Auch ist eine erneute Anbringung der Brücken 14 ermöglicht. Hierbei wird der elektrische Stromsensor 52 und der elektrische Spannungssensor 50 der Abschaltvorrichtung 12 herangezogen, wobei mittels der jeweiligen A/D-Wandler 56 die analogen Messdaten in jeweils ein digitales Wort umgesetzt werden. Mittels der Steuereinheit 48 werden insbesondere typische Charakteristika des Störlichtbogens 60 identifiziert. Sofern der Störlichtbogen 60 identifiziert wurde, wird der Schalter 46 betätigt, sodass der String 10 elektrisch von dem Gleichspannungsumrichter 18 getrennt wird.

Mittels der Mittelung über das vierte und fünfte Zeitfenster 66, 72 werden hochfrequente Elemente herausgefiltert, die insbesondere aufgrund der Betätigung der Halbleiterelemente 22 entstehen. Mit anderen Worten erfolgt eine Glättung. Hierbei ist die Länge des vierten und fünften Zeitfensters 76,72 derart gewählt, dass mindestens jeweils 20 Messwerte zur Ermittlung des ersten bzw. zweiten Werts 64, 70 herangezogen werden, sodass eine genügende Genauigkeit erreicht ist.

Aufgrund der vergleichsweise hohen Batteriekapazität steigt die elektrische Spannung 30 bei Auftritt des Störlichtbogens 60 um mindestens 15 Volt an, wohingegen der elektrische Strom 32 exponentiell abfällt, wobei der Exponent anfänglich gleich dem negativen Quotienten aus der Anfangsspannung des Lichtbogens 60 sowie der Systeminduktivität ist. Nach einer bestimmten Zeitdauer lassen diese Effekte aufgrund einer Entladung der einzelnen Batteriesysteme 4 und der Nachregelung nach.

Als erste Bedingung wird überprüft, ob der erste Wert 64 sich innerhalb des ersten Zeitfensters 46 um mehr als den ersten Grenzwert 78 ändert. Aufgrund der Mittelwertbildung entspricht dies somit der Überprüfung, ob die Differenz zwischen dem von rechts kommenden und dem von links kommenden gleitenden Durchschnitt der elektrischen Spannung oberhalb des ersten Grenzwerts 78 ist. Ferner wird als die zweite Bedingung überprüft, ob der zweite Wert 70 sich innerhalb des zweiten Zeitfensters 82 um mehr als den zweiten Grenzwert 84 ändert, also ob die Differenz zwischen dem von links und von rechts ermittelten gleitenden Durchschnitts des elektrischen Stroms 32 größer als der zweite Grenzwert 84 ist, wobei als zweiter Grenzwert 84 beispielsweise der negative Quotient aus dem ersten Grenzwert 78 und dem Doppelten der Systeminduktivität gewählt wird.

Ferner wird überprüft, ob die erste Bedingung im Wesentlichen zeitglich mit der zweiten Bedingung auftritt oder aber zumindest innerhalb des dritten Zeitfenster 88, wobei beispielsweise lediglich der Lichtbogen 60 erkannt wird, falls die beiden Bedingungen innerhalb des dritten Zeitfensters 88 vorhanden sind. Beispielsweise wird zusätzlich überprüft, ob die zweite Bedingung erst zeitlich nach der ersten Bedingung eintritt. Anderenfalls ist der Lichtbogen 60 nicht erkannt. Ferner wird in dem zehnten Arbeitsschritt 90 überprüft, ob die elektrische Spannung 30 größer als der dritte Grenzwert 92 vor dem angenommenen Zeitpunkt des Lichtbogens 60 war, und ob der minimale elektrische Strom 32 direkt vor dem angenommenen Lichtbogen 60 größer als der vierte Grenzwert war. Auch wird überprüft, ob während des angenommenen Lichtbogens 60 der fließende elektrische Strom 32 größer als der fünfte Grenzwert ist. Auf diese Weise wird ein fälschliches Erkennen des Lichtbogens 60 während eines Starts einer Bestromung, also während eines Einschaltens des Transformators 24 und/oder des Gleichspannungsumrichters 18 vermieden.

Die Erfindung ist nicht auf das vorstehend beschriebene Ausführungsbeispiel beschränkt. Vielmehr können auch andere Varianten der Erfindung von dem Fachmann hieraus abgeleitet werden, ohne den Gegenstand der Ansprüche zu verlassen. Insbesondere sind ferner alle im Zusammenhang mit dem Ausführungsbeispiel beschriebene Einzelmerkmale auch auf andere Weise miteinander kombinierbar, ohne den Gegenstand der Ansprüche zu verlassen.

### Bezugszeichenliste

- 2: Verfahren zur Herstellung von elektrischen Batteriesystemen
- 4: Batteriesystem
- 6: erster Arbeitsschritt
- 8: zweiter Arbeitsschritt
- 10: String
- 12: Abschaltvorrichtung
- 14: Brücke
- 16: dritter Arbeitsschritt
- 18: Gleichspannungsumrichter
- 20: Brückenschaltung
- 22: Halbleiterschalter
- 24: Transformator
- 26: Wechselstromnetz
- 28: vierter Arbeitsschritt
- 30: elektrische Spannung
- 32: elektrischer Strom
- 34: Hinleiter
- 36: Rückleiter
- 38: erster Anschluss
- 40: zweiter Anschluss
- 42: dritter Anschluss
- 44: vierter Anschluss
- 46: Schalter
- 48: Steuereinheit
- 50: elektrischer Spannungssensor
- 52: elektrischer Stromsensor
- 54: Sensorsonde
- 56: A/D-Wandler
- 58: Verfahren zur Erkennung von Störlichtbögen
- 60: Störlichtbogen
- 62: fünfter Arbeitsschritt
- 64: erster Wert
- 66: viertes Zeitfenster
- 68: sechster Arbeitsschritt
- 70: zweiter Wert
- 72: fünftes Zeitfenster
- 74: siebter Arbeitsschritt
- 76: erstes Zeitfenster
- 78: erster Grenzwert
- 79: Zündzeitpunkt
- 80: achter Arbeitsschritt
- 82: zweites Zeitfenster
- 84: zweiter Grenzwert
- 86: neunter Arbeitsschritt
- 88: drittes Zeitfenster
- 90: zehnter Arbeitsschritt
- 92: dritter Grenzwert
- 94: vierter Grenzwert
- 96: fünfter Grenzwert
- 98: elfter Arbeitsschritt
- 100: zwölfter Arbeitsschritt
- 102: dreizehnter Arbeitsschritt

## Patentansprüche

1. Verfahren (58) zur Erkennung von Störlichtbögen (60) bei der Ladung von elektrischen Batteriesystemen (4), die elektrisch in Reihe zu einem String (10), der mittels eines Gleichspannungsumrichters (18) gespeist wird, verschaltet sind, bei dem
- ein zu einer an dem String (10) anliegenden elektrischen Spannung (30) korrespondierender erster Wert (64) erstellt wird,
- ein zu einem über den String (10) fließenden elektrischen Strom (32) korrespondierender zweiter Wert (70) erstellt wird,
- als erste Bedingung überprüft wird, ob der erste Wert (64) innerhalb eines ersten Zeitfensters (76) um mehr als einen ersten Grenzwert (78) ansteigt,
- als zweite Bedingung überprüft wird, ob der zweite Wert (70) sich innerhalb eines zweiten Zeitfensters (82) um mehr als einen zweiten Grenzwert (84) verringert, und
- ein Lichtbogen (60) erkannt wird, wenn die erste Bedingung und die zweite Bedingung innerhalb eines dritten Zeitfensters (88) vorliegen.

2. Verfahren (58) nach Anspruch 1,
**dadurch gekennzeichnet,**
**dass** der erste Wert (64) mittels Mittelung der über ein viertes Zeitfenster (66) an dem String (10) anliegenden elektrischen Spannung (30) erstellt wird, und/oder dass der zweite Wert (70) mittels Mittelung des über ein fünftes Zeitfenster (72) über den String (10) fließenden elektrischen Stroms (32) erstellt wird.

3. Verfahren (58) nach Anspruch 2,
**dadurch gekennzeichnet,**
**dass** die Länge des vierten bzw. fünften Zeitfensters (66, 72) konstant gewählt wird und dem Kehrwert des Produkts aus dem Doppelten der Anzahl der Phasen des Gleichspannungsumrichters (18) und einer Speisefrequenz des Gleichspannungsumrichters (18) oder einem ganzzahligen Mehrfachen davon entspricht.

4. Verfahren (58) nach Anspruch 2 oder 3,
**dadurch gekennzeichnet,**
**dass** die Länge des dritten Zeitfensters (88) gleich der Länge des vierten oder fünften Zeitfensters (66, 72) gewählt wird.

5. Verfahren (58) nach einem der Ansprüche 1 bis 4,
**dadurch gekennzeichnet,**
**dass** der erste Grenzwert (78) kleiner als 12 V und/oder größer als 6 V gewählt wird.

6. Verfahren (58) nach einem der Ansprüche 1 bis 5,
**dadurch gekennzeichnet,**
**dass** der zweite Grenzwert (84) gleich dem Quotienten aus dem ersten Grenzwert (78) und dem Doppelten einer Systeminduktivität gewählt wird.

7. Verfahren (58) nach einem der Ansprüche 1 bis 6,
**dadurch gekennzeichnet,**
**dass** die Länge des ersten und/oder zweiten Zeitfensters (66, 72) konstant gewählt wird und dem Kehrwert des Produkts aus dem Doppelten der Anzahl der Phasen des Gleichspannungsumrichters (18) und einer Speisefrequenz des Gleichspannungsumrichters (18) oder einem ganzzahligen Mehrfachen davon entspricht.

8. Verfahren (58) nach einem der Ansprüche 1 bis 7,
**dadurch gekennzeichnet,**
**dass** der Lichtbogen (60) nur erkannt wird,
- wenn die vor dem dritten Zeitfenster (88) an dem String (10) anliegende elektrische Spannung (30) größer als ein dritter Grenzwert (92) ist,
- wenn der vor dem dritten Zeitfenster (88) über den String (10) fließende elektrische Strom (32) größer als ein vierter Grenzwert (94) ist, und/oder
- wenn der während des dritten Zeitfensters (88) über den String (10) fließende elektrische Strom (32) größer als ein fünfter Grenzwert (96) ist.

9. Verfahren (2) zur Herstellung von elektrischen Batteriesystemen (4), insbesondere Bleiakkumulatoren, bei dem
- eine Anzahl an ungeladenen Batteriesystemen (4) bereitgestellt wird,
- die ungeladenen Batteriesystemen (4) elektrisch in Reihe zu einem String (10) verschaltet werden,
- der String (10) elektrisch mit einem Gleichspannungsumrichter (18) kontaktiert wird,
- mittels des Gleichspannungsumrichters (18) eine elektrische Spannung (30) an dem String (10) angelegt und ein elektrischer Stromfluß (32) über den String (10) erstellt wird, und
- ein Verfahren (58) zur Erkennung von Störlichtbögen (60) ausgeführt wird, bei dem
- ein zu einer an dem String (10) anliegenden elektrischen Spannung (30) korrespondierender erster Wert (64) erstellt wird,
- ein zu einem über den String (10) fließenden elektrischen Strom (32) korrespondierender zweiter Wert (70) erstellt wird,
- als erste Bedingung überprüft wird, ob der erste Wert (64) innerhalb eines ersten Zeitfensters (76) um mehr als einen ersten Grenzwert (78) ansteigt,
- als zweite Bedingung überprüft wird, ob der zweite Wert (70) sich innerhalb eines zweiten Zeitfensters (82) um mehr als einen zweiten Grenzwert (84) verringert, und
- ein Lichtbogen (60) erkannt wird, wenn die erste Bedingung und die zweite Bedingung innerhalb eines dritten Zeitfensters (88) vorliegen.

10. Verfahren (2) nach Anspruch 9,
**dadurch gekennzeichnet,**
**dass** der String (10) elektrisch von dem Gleichspannungsumrichter (18) getrennt wird, wenn der Lichtbogen (60) erkannt wird.

11. Abschaltvorrichtung (12) zur elektrischen Unterbrechung eines Strings (10), der eine Anzahl von elektrisch in Reihe geschalteten Batteriesystemen (4) aufweist, von einer Gleichspannungsquelle, insbesondere Gleichspannungsumrichter (18), mit einem elektrischen Stromsensor (52), und mit einem elektrischen Spannungssensor (50), sowie mit einer Steuereinheit (48), die gemäß einem Verfahren (58) nach einem der Ansprüche 1 bis 8 betrieben ist.

## Claims

1. Method (58) for detecting arcs (60) when charging electric battery systems (4), which are electrically connected in series to form a string (10), which is supplied by means of a DC voltage converter (18), in which method
- a first value (64) corresponding to an electrical voltage (30) applied to the string (10) is generated,
- a second value (70) corresponding to an electric current (32) flowing through the string (10) is generated,
- a check is carried out, as a first condition, to determine whether the first value (64) increases by more than a first limit value (78) within a first time window (76),
- a check is carried out, as a second condition, to determine whether the second value (70) decreases by more than a second limit value (84) within a second time window (82), and
- an arc (60) is detected when the first condition and the second condition are met within a third time window (88).

2. Method (58) according to Claim 1,
**characterized**
**in that** the first value (64) is generated by averaging the electrical voltage (30) applied to the string (10) over a fourth time window (66), and/or in that the second value (70) is generated by averaging the electric current (32) flowing through the string (10) over a fifth time window (72).

3. Method (58) according to Claim 2,
**characterized**
**in that** the length of the fourth or fifth time window (66, 72) is selected to be constant and corresponds to the reciprocal of the product of twice the number of phases of the DC voltage converter (18) and a supply frequency of the DC voltage converter (18) or to an integer multiple thereof.

4. Method (58) according to Claim 2 or 3,
**characterized**
**in that** the length of the third time window (88) is selected to be equal to the length of the fourth or fifth time window (66, 72).

5. Method (58) according to any one of Claims 1 to 4,
**characterized**
**in that** the first limit value (78) is selected to be lower than 12 V and/or greater than 6 V.

6. Method (58) according to any one of Claims 1 to 5,
**characterized**
**in that** the second limit value (84) is selected to be equal to the quotient of the first limit value (78) and twice a system inductance.

7. Method (58) according to any one of Claims 1 to 6,
**characterized**
**in that** the length of the first and/or second time window (66, 72) is selected to be constant and corresponds to the reciprocal of the product of twice the number of phases of the DC voltage converter (18) and a supply frequency of the DC voltage converter (18) or to an integer multiple thereof.

8. Method (58) according to any one of Claims 1 to 7,
**characterized**
**in that** the arc (60) is detected only
- if the electrical voltage (30) applied to the string (10) prior to the third time window (88) is greater than a third limit value (92),
- if the electric current (32) flowing through the string (10) prior to the third time window (88) is greater than a fourth limit value (94), and/or
- if the electric current (32) flowing through the string (10) during the third time window (88) is greater than a fifth limit value (96).

9. Method (2) for manufacturing electric battery systems (4), in particular lead-acid storage batteries, in which method
- a number of uncharged battery systems (4) is provided,
- the uncharged battery systems (4) are electrically connected in series to form a string (10),
- the string (10) is electrically contacted by a DC voltage converter (18),
- an electrical voltage (30) is applied to the string (10) by means of the DC voltage converter (18) and an electric current flow (32) through the string (10) is generated, and
- a method (58) for detecting arcs (60) is performed, in which method
- a first value (64) corresponding to an electrical voltage (30) applied to the string (10) is generated,
- a second value (70) corresponding to an electric current (32) flowing through the string (10) is generated,
- a check is carried out, as a first condition, to determine whether the first value (64) increases by more than a first limit value (78) within a first time window (76),
- a check is carried out, as a second condition, to determine whether the second value (70) decreases by more than a second limit value (84) within a second time window (82), and
- an arc (60) is detected when the first condition and the second condition are met within a third time window (88).

10. Method (2) according to Claim 9,
**characterized**
**in that** the string (10) is electrically disconnected from the DC voltage converter (18) when the arc (60) is detected.

11. Cut-off device (12) for the electrical interruption of a string (10), which has a number of battery systems (4) electrically connected in series, from a DC voltage source, in particular a DC voltage converter (18), having an electric current sensor (52), and having an electric voltage sensor (50), and also having a control unit (48), which is operated in accordance with a method (58) according to any one of Claims 1 to 8.

## Revendications

1. Procédé (58) pour le repérage d'arcs électriques parasites (60) pendant la charge de systèmes de batteries électriques (4), qui sont montés électriquement en série de manière à former une chaîne (10) qui est alimentée au moyen d'un convertisseur de courant continu (18), dans lequel
- une première valeur (64) correspondant à une tension électrique (30) appliquée à la chaîne (10) est établie,
- une deuxième valeur (70) correspondant à un courant électrique (32) circulant sur toute la chaîne (10) est établie,
- une vérification est effectuée, en tant que première condition, pour déterminer si la première valeur (64) augmente de plus d'une première valeur limite (78) à l'intérieur d'une première fenêtre temporelle (76),
- une vérification est effectuée, en tant que deuxième condition, pour déterminer si la deuxième valeur (70) diminue de plus d'une deuxième valeur limite (84) pendant une deuxième fenêtre temporelle (82), et
- un arc électrique (60) est repéré lorsque la première condition et la deuxième condition sont présentes à l'intérieur d'une troisième fenêtre temporelle (88).

2. Procédé (58) selon la revendication 1,
**caractérisé en ce que**
la première valeur (64) est établie par moyennage de la tension électrique (30) appliquée à la chaîne (10) au cours d'une quatrième fenêtre temporelle (66), et/ou **en ce que** la deuxième valeur (70) est établie par moyennage du courant électrique (32) circulant sur toute la chaîne (10) au cours d'une cinquième fenêtre temporelle (72).

3. Procédé (58) selon la revendication 2,
**caractérisé en ce que**
la longueur de la quatrième ou de la cinquième fenêtre temporelle (66, 72) est choisie constante et correspond à l'inverse du produit du double du nombre de phases du convertisseur de courant continu (18) par une fréquence d'alimentation du convertisseur de courant continu (18), ou à un multiple entier de celle-ci.

4. Procédé (58) selon la revendication 2 ou 3,
**caractérisé en ce que**
la longueur de la troisième fenêtre temporelle (88) est choisie égale à la longueur de la quatrième ou de la cinquième fenêtre temporelle (66, 72).

5. Procédé (58) selon l'une quelconque des revendications 1 à 4,
**caractérisé en ce que**
la première valeur limite (78) est choisie inférieure à 12 V et/ou supérieure à 6 V.

6. Procédé (58) selon l'une quelconque des revendications 1 à 5,
**caractérisé en ce que**
la deuxième valeur limite (84) est choisie égale au quotient de la première valeur limite (78) et du double d'une inductance du système.

7. Procédé (58) selon l'une quelconque des revendications 1 à 6,
**caractérisé en ce que**
la longueur de la première et/ou de la deuxième fenêtre temporelle (66, 72) est choisie constante et correspond à l'inverse du produit du double du nombre de phases du convertisseur de courant continu (18) par une fréquence d'alimentation du convertisseur de courant continu (18), ou à un multiple entier de celle-ci.

8. Procédé (58) selon l'une quelconque des revendications 1 à 7,
**caractérisé en ce que**
l'arc électrique (60) n'est repéré que
- si la tension électrique (30) appliquée à la chaîne (10) avant la troisième fenêtre temporelle (88) est supérieure à une troisième valeur limite (92),
- si le courant électrique (32) circulant sur toute la chaîne (10) avant la troisième fenêtre temporelle (88) est supérieur à une quatrième valeur limite (94), et/ou
- si le courant électrique (32) circulant sur toute la chaîne (10) pendant la troisième fenêtre temporelle (88) est supérieur à une cinquième valeur limite (96).

9. Procédé (2) pour la fabrication de systèmes de batteries électriques (4), en particulier d'accumulateurs au plomb, dans lequel
- un certain nombre de systèmes de batteries (4) non chargés est fourni,
- les systèmes de batteries (4) non chargés sont montés électriquement en série de manière à former une chaîne (10),
- la chaîne (10) est mise en contact électrique avec un convertisseur de courant continu (18),
- une tension électrique (30) est appliquée à la chaîne (10) au moyen du convertisseur de courant continu (18) et un flux de courant électrique (32) est établi sur toute la chaîne (10), et
- un procédé (58) pour le repérage d'arcs électriques parasites (60) est exécuté, dans lequel
- une première valeur (64) correspondant à une tension électrique (30) appliquée à la chaîne (10) est établie,
- une deuxième valeur (70) correspondant à un courant électrique (32) circulant sur toute la chaîne (10) est établie,
- une vérification est effectuée, en tant que première condition, pour déterminer si la première valeur (64) augmente de plus d'une première valeur limite (78) à l'intérieur d'une première fenêtre temporelle (76),
- une vérification est effectuée, en tant que deuxième condition, pour déterminer si la deuxième valeur (70) diminue de plus d'une deuxième valeur limite (84) pendant une deuxième fenêtre temporelle (82), et
- un arc électrique (60) est repéré lorsque la première condition et la deuxième condition sont présentes à l'intérieur d'une troisième fenêtre temporelle (88).

10. Procédé (2) selon la revendication 9,
**caractérisé en ce que**
la chaîne (10) est séparée électriquement du convertisseur de courant continu (18) lorsque l'arc électrique (60) est repéré.

11. Dispositif coupe-circuit (12) pour la déconnexion électrique d'une chaîne (10), qui comporte un certain nombre de systèmes de batteries électriques (4) montés en série, d'une source de courant continu, en particulier d'un convertisseur de courant continu (18), comprenant un capteur de courant électrique (52), et un capteur de tension électrique (50), ainsi qu'une unité de commande (48) qui est amenée à fonctionner conformément à un procédé (58) selon l'une quelconque des revendications 1 à 8.
